# EUROPÄISCHE PATENTSCHRIFT

(11) **EP 4 323 784 B1**
(45) Veröffentlichungstag und Bekanntmachung des Hinweises auf die Patenterteilung: **05.03.2025**
(21) Anmeldenummer: 22722269.2
(22) Anmeldetag: 12.04.2022
(51) Int. Cl.: G01R 31/311

(54) **WAFER-LEVEL-TESTVERFAHREN FÜR OPTO-ELEKTRONISCHE CHIPS**
WAFER-LEVEL TEST METHOD FOR OPTOELECTRONIC CHIPS
PROCÉDÉ DE TEST NIVEAU TRANCHE POUR PUCES OPTO-ÉLECTRONIQUES

(30) Priorität: 16.04.2021 DE 102021109605; 21.04.2021 DE 102021110102
(43) Veröffentlichungstag der Anmeldung: 21.02.2024
(73) Patentinhaber: JENOPTIK Optical Systems GmbH, 07745 Jena (DE)
(72) Erfinder: KARRAS, Christian, 07745 Jena (DE); GNAUSCH, Tobias, 07745 Jena (DE); BUETTNER, Robert, 07745 Jena (DE); REETZ, Kay, 07745 Jena (DE); GRUNDMANN, Armin, 07745 Jena (DE); KADEN, Thomas, 01109 Dresden (DE)
(74) Vertreter: Waldauf, Alexander
(86) Internationale Anmeldenummer: PCT/EP2022/059758
(87) Internationale Veröffentlichungsnummer: WO 2022/218983

(56) Entgegenhaltungen:
- DE-A1- 102013 223 034
- DE-A1- 102018 108 283
- US-A1- 2021 096 176
- US-B1- 7 378 861
- DE COSTER JEROEN ET AL: "Test-station for flexible semi-automatic wafer-level silicon photonics testing", 2016 21TH IEEE EUROPEAN TEST SYMPOSIUM (ETS), IEEE, 23 May 2016 (2016-05-23), pages 1 - 6, XP032928385, DOI: 10.1109/ETS.2016.7519306

## Beschreibung

### Technisches Gebiet

Die Erfindung betrifft ein Verfahren mit dem in einem Waferprober zeitgleich die Funktionalität von elektrischen und optischen Komponenten bzw. Schaltungen eines Chips auf Wafer - Ebene getestet werden kann. Ein solches Verfahren ist gattungsgemäß aus der US 2011/0279812 A1 bekannt.

Die Erfindung ist im Bereich des Testens und Qualifizierens von Chips mit optisch-elektrisch integrierten Schaltungen, sogenannten PICs (Photonic Integrated Circuits), auf Wafer-Ebene angesiedelt. Im Unterschied zu herkömmlichen, rein elektrisch integrierten Schaltungen, sogenannten ICs (Integrated Circuits), sind bei PICs neben den elektrischen Schaltungen auch optische Funktionalitäten integriert.

Bei der Herstellung von ICs, z. B. mittels CMOS-Technologie, finden in verschiedenen Herstellungsschritten Tests und Messungen statt, um einerseits den Prozess zu überwachen und andererseits eine Qualitätskontrolle durchzuführen. Ein etablierter Test ist dabei der elektrische Wafer Level Test nach der Fertigstellung des Wafers. Hier werden funktionale und nicht-funktionale Chips ermittelt, in einer Wafermap erfasst und damit die Ausbeute bestimmt. Funktionale Chips werden auch als Known Good Dies (KGD) bezeichnet. Beim Vereinzeln des Wafers in einzelne Chips erfolgt dann das Aussortieren der nicht funktionalen Chips. Die für den Wafer Level Test benötigte Testapparatur steht in Form von Waferprobern und Wafertestern mit zugehörigen Kontaktierungsmodulen (auch Probecards genannt) zur Verfügung. Mittels des Kontaktierungsmoduls werden die geräteseitigen Schnittstellen des Wafertesters mit den individuellen Schnittstellen der Chips des auf dem Waferprober fixierten Wafers verbunden. Grundsätzlich kann das Kontaktierungsmodul so ausgeführt sein, dass es nur einen oder aber auch zeitgleich mehrere Chips kontaktiert. Es ist auch nicht zwingend erforderlich, dass die Chips zur Kontaktierung noch im Waferverbund vorliegen. Um gleichzeitig mehrere oder auch nacheinander die Chips eines Wafers zu kontaktieren, müssen die Chips lediglich eine fixierte und definierte Lage zueinander aufweisen.

Testapparaturen zum Testen rein elektronischer Chips (Halbleiterchip mit ICs) wurden über Jahrzehnte optimiert und diversifiziert, um zur Kostenoptimierung hohe Volumina unterschiedlichster ICs mit hohem Durchsatz qualifizieren zu können.

Die Herstellung der PICs erfolgt i.d.R. mit den gleichen etablierten Halbleiterprozessen, z. B. der CMOS-Technologie. Die bisher im Vergleich zur IC-Herstellung sehr geringen Fertigungsvolumina von PICs führen dazu, dass i.d.R. in einer Halbleiterfabrik nur Tests zur Prozesscharakterisierung, aber keine funktionalen Tests der PICs durchgeführt werden. Die funktionale Charakterisierung obliegt dem Endkunden und wird oft an gesägten Chips durchgeführt. Die benutzte Testapparatur verwendet voneinander unabhängige, getrennte elektrische und optische Kontaktierungsmodule und ist nicht auf Durchsatz optimiert.

### Stand der Technik

Das Testen von PICs auf Wafer-Level-Ebene erfordert das Ein- und Auskoppeln von Licht in die bzw. aus der Ebene der PICs, i.d.R. mittels integrierter Grating-Koppler als Koppelstellen, wie in der Fachliteratur "Grating Couplers for Coupling between Optical Fibers and Nanophotonic Waveguides" (D. Taillaert et al, Japanese Journal of Applied Phys[i]cs, Vol. 45, No. 8A, 2006, S. 6071-6077) beschrieben. Die Gitterkoppler (Grating Couplers) können funktionaler Bestandteil im Chip oder Opferstrukturen auf dem Wafer z. B. im Ritzgraben oder auf benachbarten Chips sein.

Dem Stand der Technik entsprechend werden glasfaserbasierte Systeme für den Wafer Level Test verwendet, wie in der Fachliteratur: "Test-station for flexible semi-automatic wafer-level silicon photonics testing" beschrieben (J. De Coster et al, 21th IEEE European Test Symposium, ETS 2016, Amsterdam, Netherlands, May 23-27, 2016. IEEE 2016, ISBN 978-1-4673-9659-2). Diese beinhalten ein glasfaserbasiertes Optikmodul, das über einzelne Glasfasern Licht in die Koppelstellen des Chips ein- und auskoppelt. Um eine wiederholgenaue optische Kopplung zu gewährleisten, müssen die Glasfasern zum einen submikrometergenau zu den Koppelstellen in einem Abstand bis zu wenigen Mikrometern justiert werden. Dies ist nur unter Zuhilfenahme hochpräziser Stellelemente möglich, z.B. in Kombination von Hexapoden mit Piezoelementen. Zum anderen muss vor jeder einzelnen optischen Kopplung ein zeitintensiver, aktiver und auf das Erreichen maximaler Koppeleffizienz ausgelegter Justageablauf erfolgen.

Damit sind bestehende Wafer-Level-Test-Systeme gekennzeichnet durch
- sequentielles, zeitintensives Kontaktieren aller optischen Koppelstellen eines Chips nacheinander, d. h. eine parallele Kontaktierung aller optischen Koppelstellen eines Chips ist nicht oder nur stark eingeschränkt möglich, eine parallele Kontaktierung mehrerer Chips gar nicht möglich.
- geräteseitige Sonderlösungen, so dass herkömmliche Waferprober nur mit aufwendigen und kostenintensiven Modifikationen umrüstbar und danach nicht mehr oder nur bedingt bzw. erst nach zeitaufwendiger Umrüstung für den Wafer Level Test von ICs einsetzbar sind.
- getrennte, nicht fest miteinander verbundene Elektronik- und Optikmodule, d. h. beide müssen separat gehaltert und justiert werden.

Aus der vorgenannten US 2006/0109015 A1 ist ein optoelektronisches Kontaktierungsmodul (probe module) zum Testen von Chips (zu untersuchendes Objekt - DUT 140) mit elektrischen und optischen Ein- und Ausgängen bekannt. Das Kontaktierungsmodul stellt eine Schnittstelle zwischen einer Testapparatur (ATE) und dem Testobjekt (device under test, kurz DUT) dar und ist mit elektrischen Kontakten (electical probes), optischen Kontakten (optical probes), optischen Elementen und Kombinationen hiervon ausgeführt, um Signale von dem DUT und zu dem DUT zu leiten und diese Signale umzuverteilen für eine Schnittstelle zur Testapparatur.

Zu den optischen Ein- und Ausgängen ist offenbart, dass diese über optische Elemente geschaffen sind, die sich auf der Kontaktierungsplatte und / oder der Umverteilungsplatte befinden und auf verschiedene Einkoppelmechanismen, z. B. Freistrahlung, Quasifreistrahlung oder Wellenleiter, abgestimmt sind. Als hierfür geeignete optische Elemente sind diffraktive Elemente und refraktive Elemente angegeben. Auch ist angegeben, dass ein Photodetektor oder eine Lichtquelle direkt an der Schnittstelle zum DUT angeordnet sein können, die dann den optischen Ein- oder Ausgang an der Kontaktierungsplatte darstellen.

Darüber hinaus lehrt die vorgenannte US 2006/0109015 A1, dass für Ausführungen der optischen Einkopplung über Freistrahl- oder Quasifreistrahlverbindungen, bei denen das optische Signal durch einen Freiraum zwischen dem optischen Element und der Schnittstelle zum DUT geleitet wird, das optische Signal fokussiert oder kollimiert wird, um eine hohe Einkoppeleffizienz des übertragenen Signals zu erreichen. Die Signaleinkopplung unterliegt hier folglich dem Konzept, das Signal möglichst vollständig einzukoppeln.

Nach einem Ausführungsbeispiel der vorgenannten US 2006/0109015 A1 sind die optischen und die elektrischen Signalleitungen (optisches und elektrisches Verteilernetz) auf separaten Umverteilungsplatten ausgeführt. Es wird vorgeschlagen, die elektrischen Signale von dem DUT zu den Randbereichen der Kontaktierungsplatte zu führen, so dass in der oberhalb der Kontaktierungsplatte angeordneten ersten Umverteilungsplatte die elektrischen Signale oberhalb des Randbereiches eingekoppelt werden. Dadurch kann in der ersten Umverteilungsplatte, in der nur die elektrischen Signale umverteilt werden, eine Öffnung ausgebildet sein, durch die hindurch die optischen Signale in eine darüber angeordnete separate zweite Umverteilungsplatte geführt werden.

Zusammenfassend werden in der vorgenannten US 2006/0109015 A1 eine Vielzahl von Ideen aufgezeigt, wie ein Kontaktierungsmodul, das begründet, z. B. durch den Verschleiß der mechanischen Kontakte für die elektrische Signalübertragung, in eine Kontaktierungsplatte und eine Umverteilungsplatte unterteilt ist, zusätzlich mit optischen Signalleitungen ausgestattet werden könnte. Dabei wird völlig außer Betracht gelassen, dass die für den mechanischen Kontakt der elektrischen Ein- und Ausgänge des Kontaktierungsmoduls zum DUT möglichen Toleranzen nicht auf die optischen Ein- und Ausgänge übertragbar sind.

Während die Übertragung eines stets gleichen elektrischen Signals lediglich einen mechanischen Kontakt von an dem Kontaktierungsmodul vorhandenen Nadeln mit an dem DUT vorhandenen Kontaktplättchen (Kontaktpads) erfordert, was innerhalb einer vergleichsweise großen Lagetoleranz von einigen µm in alle drei Raumrichtungen gesichert werden kann, wird die Qualität der optischen Signalübertragung bereits bei einer sehr viel kleineren, im Sub-µm-Bereich liegenden Abweichung von einer Solllage beeinflusst.

Erfolgt, wie in der vorgenannten US 2006/0109015 A1 beschrieben, eine Optimierung der Koppeleffizienz des optischen Signals durch eine Kollimation oder Fokussierung des optischen Strahls, muss das gesamte Kontaktierungsmodul hochpräzise im Sub-µm-Bereich justiert werden. Andernfalls ist die justageabhängige Wiederholgenauigkeit der Messung nicht ausreichend für die beschriebenen Anwendungen. Das wiederum hat zur Folge, dass das Kontaktierungsmodul nicht die in herkömmlichen elektrischen Waferprobern typischen Justagetoleranzen für die elektrische Kontaktierung im Bereich von einigen Mikrometern in X-, Y- und Z-Richtung ausschöpfen kann. Es werden aufwendige und teure Waferprober-Sonderlösungen u. a. mit diversen Stellelementen, wie zum Beispiel Piezostellelementen, und Linearachsen oder Hexapoden benötigt, um das Kontaktierungsmodul hochgenau zum DUT zu justieren.

Ein weiterer kritischer Punkt ist, dass für die saubere elektrische Justage der Nadeln ein sogenannter Overdrive von typisch einigen 10 µm in Z-Richtung eingestellt wird, d. h., dass nach Erstkontakt der Nadeln mit den elektrischen Kontaktpads das Kontaktierungsmodul noch um einen zusätzlichen Betrag in Z-Richtung verfahren wird, um eine zuverlässige elektrische Kontaktierung zu gewährleisten. Abnutzung und Verformung der Nadeln werden i.d.R. durch eine Anpassung des Overdrives während des Betriebes gegenkompensiert. Bei einer einfachen Kollimation oder Fokussierung des optischen Strahls, wie in der vorgenannten US 2006/0109015 A1 beschrieben, darf für eine wiederholgenaue Kopplung der Arbeitsabstand in Z-Richtung jedoch nur im Bereich um Mikrometer schwanken. Damit ist diese Art der optischen Kopplung nicht kompatibel mit etablierten elektrischen Kontaktierungsverfahren.

Die US 2011/0279812 A1 offenbart ein Kontaktierungsmodul zum Testen von Chips mit elektrischen und optischen Ein- und Ausgängen. Der Chip ist auf einem beweglichen Träger aufgenommen, mit dem er sich grob zum Kontaktierungsmodul ausrichten lässt. Die Grobausrichtung erfolgt sensorgesteuert anhand einer Positionsüberwachung des Chips oder der Justiermarken des Chips. Die Feinausrichtung des Chips erfolgt in zwei Verfahrensschritten. Im ersten Verfahrensschritt wird überprüft, ob die elektrischen Ein- und Ausgänge in Kontakt zum Kontaktierungsmodul stehen. Der Chip wird dazu mit dem Kontaktierungsmodul angesaugt, sodass die elektrischen Ein- und Ausgänge des Chips mit den elektrischen Kontakten des Kontaktierungsmoduls in Kontakt kommen. Mittels eines Testsignals wird auf eine erfolgreiche Kontaktierung geprüft und bei fehlerhafter Kontaktierung mittels einer wiederholten Grobausrichtung korrigiert. Im zweiten Verfahrensschritt erfolgt die Ausrichtung an den optischen Ein- und Ausgängen. Die optischen Ein- und Ausgänge des Chips können fokussierte oder kollimierte Strahlen mit angepasster Apertur und Fokusposition empfangen oder aussenden. Die optischen Ein- und Ausgänge des Kontaktierungsmoduls verfügen über variable Optiken, mit denen senkrecht auf die Oberfläche der optischen Ein- und Ausgänge fokussierte Strahlen erzeugt werden können, wobei die axiale und seitliche Fokuslage und die Apertur der Strahlen anpassbar sind. Für die Anpassung verfügt die variable Optik über mindestens ein optisches Element mit veränderbarer Brennweite und/oder mindestens ein optisches Element, das beweglich ist. Die axiale Anpassung der Fokuslage erfolgt auf Grundlage von Abstandsmessungen mittels zusätzlicher Abstandssensoren oder von Intensitätsmessungen anhand eines optischen Testsignals. Die seitliche Anpassung der Fokuslage erfolgt auf Grundlage von Intensitätsmessungen, bei denen ein bereits auf die Oberfläche des Chips fokussierter Teststrahl in einer scannenden Relativbewegung gegenüber den optischen Ein- und Ausgängen bewegt wird, bis der Teststrahl optimal in die optischen Ein- und Ausgänge eingekoppelt wird. Die dafür benötigte Zeit kann verkürzt werden, indem die scannende Relativbewegung zunächst mit einem vergrößerten Fokusdurchmesser des Teststrahls ausgeführt wird. Nach der Feinausrichtung erfolgt der Test des Chips mittels spezieller elektrischer und optischer Testsignalsequenzen, wobei beim Testen mehrerer gleichartiger Chips Teile der Grob- und Feinjustage abgespeichert und weiter verwendet werden können.

Aus DE 102018108283 A1 ist eine elektro-optische Leiterplatte zur Kontaktierung von photonischen integrierten Schaltungen bekannt, bei der ein optischer Strahlengang durch die Leiterplatte hindurch geführt wird. Nachteilig ist die geringe erreichbare Präzision der optischen Kopplung zwischen der Leiterplatte und dem zu testenden Chip.

Aus WO 2019/029765A1 ist ein Lagetoleranzunempfindliches Kontaktierungsmodul zur Kontaktierung optoelektronischer Chips bekannt. Nachteilig ist, dass die Ausrichtung des Kontaktiermoduls zu dem zu testenden Chip suboptimal sein kann.

Aus DE10 2013 223034 A1 ist eine optische Koppelvorrichtung zur optimalen Positionierung einer Faser in Bezug auf einen Gitterkoppler auf einem DUT bekannt, beispielsweise bei einem On-Wafer-Testverfahren, wobei allerdings keine elektrische Kopplung beschrieben ist.

Aus US 2021 / 0096176 A1 ist ein optisches Testsystem für ein DUT bekannt, bei dem ein Scan mit einer optischen Testspitze durchgeführt wird. Nachteilig ist, dass die optische Testspitze leicht abbrechen kann und außerdem eine gleichzeitige optische und elektrische Kopplung schwierig zu realisieren ist.

Aus US 7 378 861 B1 ist ein optisches Ausrichtungsverfahren für einen Wafer-Level Test optoelektronischer Chips bekannt. Nachteilig ist die unabhängige elektrische und optische Ausrichtung, welche wenigstens zwei unabhängige Positioniersysteme erfordert
Außerdem ist ein semiautomatisches Testen von Si-Photonics DUTs auf einem Wafer bekannt (DE COSTER JEROEN ET AL: "Test-station for flexible semiautomatic wafer-level silicon photonics testing", 2016 21th IEEE EUROPEAN TEST SYMPOSIUM (ETS), IEEE, 23. Mai 2016 (2016-05-23), Seiten 1-6, XP032928385, DOI: 10.1109/ETS.2016.7519306). Hierfür wird eine optische Kontaktierung von Kopplungsgittern des DUT mittels Wellenleitern ausgeführt.

Zum Testen von elektronischen Chips auf Waferebene ist es aus der Praxis bekannt, dass mittels einer ersten Kamera die Raumlage der Spitzen der Nadeln und mit einer zweiten Kamera die Raumlage der Mittelpunkte der Kontaktpads eines Chips bestimmt werden. Aus einer daraus abgeleiteten Relativlage der Spitzen zu den Kontaktpads werden Steuersignale gebildet, mit denen ein Positioniertisch angesteuert wird und die Mittelpunkte der Kontaktpads lotrecht unterhalb der Spitzen positioniert werden, bevor die Kontaktnadeln mit den Kontaktpads in Kontakt gebracht werden.

### Aufgabe der Erfindung

Es ist die Aufgabe der Erfindung ein Verfahren zum Testen von auf einem Wafer angeordneten optoelektronischen Chips mit elektrischen Schnittstellen in Form von Kontaktpads und hierzu fest angeordneten optischen Schnittstellen in Form von optischen Umlenkelementen mit einem spezifischen Kopplungswinkel zu finden, das auf bewährten Verfahren zum Testen von elektronischen Chips basiert.

### Lösung der Aufgabe

Diese Aufgabe wird mit einem Verfahren nach Anspruch 1 zum Testen von auf einem Wafer angeordneten opto-elektronischen Chips mit elektrischen Schnittstellen in Form von Kontaktpads und hierzu fest angeordneten optischen Schnittstellen in Form von optischen Umlenkelementen gelöst.

### Beschreibung

Das erfindungsgemäße Verfahren dient zum Testen von auf einem Wafer angeordneten optoelektronischen Chips.

Die Chips weisen elektrische Schnittstellen in Form von Kontaktpads und hierzu fest angeordnete optische Elemente auf. Optische Elemente können beispielsweise passive optische Elemente, optoelektronische Aktoren und/oder optoelektronische Sensoren und/oder elektrooptische Modulatoren sein. Die optischen Elemente umfassen optische Schnittstellen in Form von optischen Umlenkelementen mit einem spezifischen Kopplungswinkel α. Die Umlenkelemente können beispielsweise als Gitterkoppler oder Spiegel ausgebildet sein. Der spezifische Kopplungswinkel α kann einen Winkel darstellen, den ein optisches Signal bzw. dessen Zentralstrahl mit einem Lot auf den Wafer einschließt. Das Lot kann die z-Richtung sein. Der spezifische Kopplungswinkel kann typischerweise größer 0° und kleiner 25° sein. Ein gängiger Wert für den spezifischen Koppelungswinkel α kann z.B. bei 11,6° liegen und vorteilhaft für die zur Kopplung in der Endanwendung des Chips verwendeten Glasfasern mit entsprechendem Keilanschliff sein. Vorteilhaft können die von mehreren, besonders vorteilhaft von allen, optischen Umlenkelementen umgelenkten Strahlen parallel sein. Die Parallelität kann, falls die optischen Elemente für Strahlenbündel ausgelegt sind, bezüglich der Zentralstrahlen der Strahlenbündel bestimmt werden. Dann kann das Koordinatensystem derart gewählt werden, dass die y-Komponenten der umgelenkten Strahlen verschwinden, d.h. dass die umgelenkten Strahlen in xz-Ebenen liegen können.

Bei dem erfindungsgemäßen Verfahren wird der Wafer von einem Positioniertisch aufgenommen, der in x-, y- und z- Richtung eines kartesischen Koordinatensystems gegenüber einem Kontaktierungsmodul verstellbar und um die z-Achse drehbar ist. Vorteilhaft können die x-und y- Koordinaten mittels des Positioniertisches verstellt werden. Vorteilhaft kann die z Koordinate ebenfalls mittels des Positioniertisches verstellt werden. Alternativ oder zusätzlich kann die Verstellbarkeit in z-Richtung mittels einer vertikalen Hub- und Senkvorrichtung des Kontaktiermoduls vorgesehen sein. Die Drehbarkeit um die z-Achse kann vorteilhaft mittels einer Drehbarkeit des Positioniertisches vorgesehen sein. Alternativ oder zusätzlich kann die Drehbarkeit um die z-Achse mittels einer Drehvorrichtung des Kontaktiermoduls vorgesehen sein. Das Kontaktierungsmodul weist den Kontaktpads zugeordnete elektrische Schnittstellen in Form von Nadeln mit Nadelspitzen auf. Außerdem weist das Kontaktierungsmodul den optischen Umlenkelementen zugeordnete optische Schnittstellen auf.

Eine eventuell vorhandene Abweichung des x-Verfahrwegs bzw y-Verfahrwegs des Positioniertisches von der x-Richtung bzw. y-Richtung des Chips kann beispielsweise mittels der o.g. Drehbarkeit um die z-Achse ausgeglichen oder mittels einer Drehmatrix im Sinne einer Rotation als lineare Koordinatentransformation (sogenannte Alias-Transformation in der xy-Ebene) bei der Steuerung der Verfahrwege des Positioniertischs kompensiert werden.

In einem ersten Ausrichtungsschritt wird der Wafer dem Kontaktierungsmodul so zugestellt, dass die Nadelspitzen in einer ersten Position (x1, y1, z1) jeweils in z-Richtung beabstandet über einer vorbestimmten Stelle des zugeordneten Kontaktpads eines ersten der Chips angeordnet sind, wobei das Kontaktierungsmodul in z-Richtung einen ersten Abstand a zu dem ersten der Chips aufweist. Dabei ist der erste Abstand a größer als ein maximaler Abstand I der Nadelspitzen zum Kontaktierungsmodul. Der maximale Abstand der Nadelspitzen zum Kontaktiermodul kann auch als eine effektive Nadellänge in z- Richtung im mechanisch unbelasteten (d.h. kraftfreien) Zustand betrachtet werden. Die vorbestimmte Stelle kann eine bestimmte xy Position, d.h. eine Stelle in einer xy Ebene, sein. Die vorbestimmte Stelle kann, muß aber nicht, die Mitte des Kontaktpads sein. Die Nadeln können beispielsweise als senkrechte (d.h. in z-Richtung angeordnete) Nadeln, sogenannte "Vertical Needles" ausgebildet sein, welche unter Umständen nur eine geringe Federwirkung haben. Vorteilhaft können die Nadeln als einfederbare senkrechte oder schräg angeordnete Nadeln ausgebildet sein. Besonders vorteilhaft können die Nadeln als Cantilever-Nadeln ausgebildet sein. Cantilever-Nadeln können solche Nadeln sein, die im Sinne eines Biegebalkens federnd angeordnet sind. Bevorzugt können Cantilever-Nadeln so angeordnet sein, dass sie bezüglich ihres Biegebalkenabschnitts im unbelasteten (kraftfreien) Zustand einen Winkel größer als 60° zur z- Achse einschließen, besonders bevorzugt größer als 70° und ganz besonders bevorzugt größer als 80°. Der erste Ausrichtungsschritt kann beispielsweise mittels einer oder mehrerer Kameras ausgeführt werden, mit deren Hilfe die erste Position aufgefunden werden kann. Alternativ kann auch eine händische Positionierung oder eine passive Positionierung mittels Anschlagen des Waferrands an vorgesehenen Anschlägen erfolgen.

Ausgehend von der ersten Position (x1, y1, z1) wird in einem zweiten Ausrichtungsschritt eine zweite Position (x2, y2, z2) ermittelt, indem der Positioniertisch dem Kontaktierungsmodul in z-Richtung in einen zweiten Abstand b zugestellt wird, bei dem die Nadelspitzen an den Kontaktpads anliegen, so dass über die jeweils einander zugeordneten Schnittstellen elektrische Signale und über die jeweils einander zugeordneten optischen Schnittstellen optische Signale übertragbar sind. Erfindungsgemäß erfolgt im zweiten Ausrichtungsschritt eine relative Ausrichtung der optischen Umlenkelemente zu den an dem Kontaktierungsmodul vorhandenen optischen Schnittstellen, indem in einem Scanfeld kleiner einer xy- Ausdehnung der Kontaktpads der Positioniertisch in Scanpositionen (xs[i], ys[i], zs[i]) innerhalb eines Scanbereichs gegenüber den x- und/oder y Koordinaten der ersten Position in x- und/oder y-Richtung ausgelenkt und/oder in z-Richtung zugestellt wird, und an den Scanpositionen P[i] = (xs[i], ys[i], zs[i]) über wenigstens eine der optischen Schnittstellen des Kontaktierungsmoduls und eines der optischen Umlenkelemente ein optisches Signal gekoppelt wird, wobei die zweite Position (x2, y2, z2) dadurch definiert ist, dass das optische Signal mit einem maximalen Kopplungsgrad gekoppelt wird, wobei der Kopplungsgrad mittels wenigstens eines über wenigstens eine elektrische Schnittstelle übertragenen elektrischen Signals bestimmt wird. Werden im zweiten Ausrichtungsschritt jeweils mehrere optische Schnittstellen gekoppelt, kann der Mittelwert des Kopplungsgrades aus den mehreren optischen Schnittstellen zur weiteren Betrachtung verwendet werden.

Als Scanbereich kann man den im Allgemeinen räumlich ausgebildeten Bereich verstehen, in dem der Scan erfolgt. Als Spezialfall kann der Scanbereich flächig ausgebildet sein, als Spezialfall dieses Spezialfalls linienförmig. Den Scanbereich kann man mathematisch als kleinstes konvexes Polyeder definieren, welches alle Scanpositionen (xs[i], ys[i], zs[i]) enthält. Der Scanbereich kann vorteilhaft zweidimensional vorgesehen sein, in diesem Fall kann das Polyeder zum Polygon entartet sein. Der Index i kann als Laufindex i=1, 2 ... imax zum fortlaufenden Durchnummerieren der Scanpositionen vorgesehen sein. Dadurch kann die zeitliche Abfolge der Scanpositionen vorbestimmt sein. Die Scanpositionen können aber auch adaptiv festgelegt werden. Das kann bedeuten, dass die Position P[i+1] erst zur Laufzeit des Scans unter Berücksichtigung der Kopplungsgrade an den Scanpositionen P[1] bis P[i] festgelegt wird. Unter dem Scanfeld kann man eine z-Projektion des Scanbereichs auf die xy-Ebene des Wafers verstehen. Das Scanfeld kann im Allgemeinen zweidimensional (d.h. flächig), als Spezialfall eindimensional (d.h. linienförmig) und als Spezialfall des Spezialfalls nulldimensional (d.h. punktförmig) sein. Unter der xy- Ausdehnung der Kontaktpads kann man dessen geometrische Erstreckung in x- und y-Richtung verstehen. Dass das Scanfeld kleiner einer xy- Ausdehnung der Kontaktpads ist, kann bedeuten, dass die Nadelspitzen das jeweils zugeordnete Kontaktpad während des Scans nicht verlassen. In einer speziellen Ausführung kann der Scan linienförmig sein, was einem eindimensionalen Scanbereich entspricht. In einem Spezialfall dieser speziellen Ausführung kann der Scan linienförmig in z-Richtung erfolgen. Dann kann das Scanfeld punktförmig sein. Das kann den Vorteil haben, dass ein Scan auch bei sehr kleinen Kontaktpads möglich ist.

An jeder der Scanpositionen P[i] kann ein Kopplungsgrad k[i] ermittelt werden. Die zweite Position (x2, y2, z2) kann eine interpolierte Maximumsposition der an den Scanpositionen ermittelten Kopplungsgrade sein. Alternativ kann man als zweite Position ohne Interpolation die Scanposition nehmen, an welcher der maximale Kopplungsgrad gemessen wurde. Am Ende des zweiten Ausrichtungsschritts kann, muss aber nicht, die ermittelte zweite Position (x2, y2, z2) angefahren werden.

Erfindungsgemäß wird in einem dritten Ausrichtungsschritt der erste der Chips an eine dritte Position (x3, y3, z3) gebracht wird, indem zunächst die x3- und y3-Koordinate des Positioniertisches eingestellt und anschließend in z-Richtung in einen dritten Abstand c, welcher kleiner als der zweite Abstand b ist, zugestellt wird, wobei die Nadelspitzen an den Kontaktpads mit einer vorbestimmten Andruckkraft anliegen, wobei die dritte Position (x3, y3, z3) aus der zweiten Position und dem Kopplungswinkel α des betreffenden optischen Umlenkelementes für den dritten Abstand c vor dem dritten Ausrichtungsschritt berechnet wurde.

Die dritte Position (x3, y3, z3) kann dadurch bestimmt sein, dass für den dritten Abstand, welcher der Koordinate z3 zugeordnet ist, an der Stelle mit den Koordinaten x3, y3 ein maximaler Kopplungsgrad vorliegt. Der dritte Abstand c kann ein vorbestimmter optischer Arbeitsabstand sein, in dem die Nadeln mit einer vorgegebenen Andruckkraft an den Kontaktpads anliegen.

Die dritte Position kann beispielsweise auf folgende Weise berechnet werden. Es kann o.B.d.A. der von einem Umlenkelement unter dem spezifischen Kopplungswinkel α umgelenkte Strahl in einer xz Ebene liegen (d.h. senkrecht zu y). Dann kann die dritte Position (x3, y3, z3) bestimmt werden zu x3 = x2+(z3-z2) tan α und y3 = y2, wobei die Koordinate z3 dadurch festgelegt sein kann, dass dort der vorgegebene Arbeitsabstand c vorhanden ist. Wie weiter unten Beschrieben, kann sich der erforderliche Arbeitsabstand c (und damit die Koordinate z3) im Laufe der Zeit ändern.

In der dritten Position können hernach zum Testen des opto-elektronischen Chips über die jeweils einander zugeordneten Schnittstellen elektrische bzw. optische Signale geleitet werden.

Vorteilhaft wird eine sich aus der ersten Position und der zweiten Position des ersten der Chips ergebende Lagedifferenz als Offset abgespeichert und für die Justierung weiterer der Chips berücksichtigt, nachdem diese in einer ersten Position zum Kontaktierungsmodul positioniert wurden.

Insbesondere um den Verschleiß der Nadelspitzen zu berücksichtigen, ist es von Vorteil, wenn der optische Arbeitsabstand c, bei dem die Nadeln mit einer vorgegebenen Andruckkraft an den Kontaktpads anliegen, überwacht wird und bei Änderungen der Andruckkraft die dritte Position korrigiert wird.

Indem die Änderung des optischen Arbeitsabstandes c langfristig über die Einsatzdauer des Kontaktierungsmoduls ermittelt wird, ist es vorteilhaft möglich für die Verfahrensdurchführung die Nadeln des Kontaktierungsmoduls gegen neue Nadeln zu ersetzen, wenn der optische Arbeitsabstand c einen vorgegebenen Minimalabstand unterschreitet.

Indem die optischen Signale die jeweilige Schnittstelle beim Einkoppeln vorteilhaft überstrahlen, werden insbesondere Lagetoleranzen der optischen Schnittstellen der Chips untereinander ausgeglichen.

Noch vorteilhafter ist es, wenn die über die jeweils einander zugeordneten Schnittstellen geleiteten optische Signale beim Einkoppeln eine Tophat-Verteilung ihrer Strahlungsintensität aufweisen.

Vorteilhaft kann sich der dritte Ausrichtungsschritt unmittelbar an den zweiten Ausrichtungsschritt anschließen. Dadurch kann die Bearbeitungszeit minimiert werden. Ebenfalls vorteilhaft kann zwischen dem zweiten und dem dritten Ausrichtungsschritt ein vierter Ausrichtungsschritt vorgesehen sein, bei dem der Positioniertisch in -z-Richtung (d.h. in negative z-Richtung) in einen vierten Abstand d abgestellt wird, wobei der vierte Abstand d größer ist als der maximale Abstand I der Nadelspitzen zum Kontaktierungsmodul. Dadurch kann das Zerkratzen der Pads reduziert werden.

Vorteilhaft können im zweiten Ausrichtungsschritt die Scanpositionen (xs[i], ys[i], zs[i]) in einer xy- Ebene (x, y, z2) liegen. Die Scanpositionen Ps[i] können dann (xs[i], ys[i], z2) sein.

Ebenfalls vorteilhaft können im zweiten Ausrichtungsschritt die Scanpositionen (xs[i], ys[i], zs[i]) in einer yz Ebene (x2, y, z) liegen. Die Scanpositionen Ps[i] können dann (x2, ys[i], zs[i]) sein. Die Scanpositionen können vorteilhaft so gewählt sein, dass z monoton steigt, d.h. z[i+1] ≥ z[i] ∀ i ∈ {1, 2, ..., imax-1}.

Ebenfalls vorteilhaft können im zweiten Ausrichtungsschritt die Scanpositionen (xs[i], ys[i], zs[i]) auf einer Linie (x2, y2, z) liegen. Die Scanpositionen Ps[i] können dann (x2, y2, zs[i]) sein. In diesem Fall kann auf eine Ausrichtung bezüglich y verzichtet werden.

Vorteilhaft kann wenigstens eines der optischen Elemente eines Chips einen elektrooptischen Sensor und /oder einen elektrooptischen Aktor und/oder einen elektrooptischen Modulator umfassen. Ein elektrooptisches Element kann elektrisch über zwei elektrische Schnittstellen kontaktiert sein. Ebenso kann es möglich sein, dass eine der elektrischen Schnittstellen durch einen Substratkontakt (Massekontakt) ersetzt wird. Bei Verwendung eines solchen Massekontakts kann eine elektrische Schnittstelle des elektrooptischen Elements für das Verfahren ausreichend sein. Beispielsweise kann die Anode eines elektrooptischen Elements auf Masse liegen und nur die Kathode über eine der elektrischen Schnittstelle geführt sein oder umgekehrt.

Vorteilhaft kann der elektrooptische Sensor als eine Photodiode oder ein Phototransistor ausgebildet sein. Dann kann im zweiten Ausrichtungsschritt der Kopplungsgrad dadurch bestimmt werden, dass über die optische Schnittstelle des Kontaktiermoduls Licht in das dem optischen Sensor zugeordnete Umlenkelement gekoppelt wird und über die entsprechenden elektrischen Schnittstellen ein Photostrom gemessen wird. Der Kopplungsgrad kann aus dem Verhältnis des Photostroms zur vom Kontaktiermodul an der Schnittstelle ausgegebenen Lichtleistung bestimmt werden.

Vorteilhaft kann der elektrooptische Aktor als eine Lichtemitterdiode (LED) oder eine Laserdiode ausgebildet sein. Eine Lichtemitterdiode kann als herkömmliche Lichtemitterdiode oder als Superlumineszenzdiode ausgebildet sein. Bei einem elektrooptischen Aktor kann im zweiten Ausrichtungsschritt der Kopplungsgrad dadurch bestimmt werden, dass dem elektrooptischen Aktor über elektrische Schnittstellen ein Betriebsstrom zugeführt wird, wodurch der Aktor Licht erzeugt. Das erzeugte Licht wird über das zugeordnete Umlenkelement der optischen Schnittstelle des Kontaktiermoduls zugeführt und die eintreffende Lichtmenge gemessen. Der Kopplungsgrad kann aus dem Verhältnis des Photostroms zur vom optischen Element an der Schnittstelle ausgegebenen Lichtleistung bestimmt werden. Als Maß für die optische Lichtleistung kann der Betriebsstrom des optischen Elements herangezogen werden.

Vorteilhaft kann der elektrooptische Modulator als ein Mach-Zehnder-Interferometer ausgebildet sein. In diesem Fall kann der Kopplungsgrad über zwei optische Schnittstellen gemessen werden. Zweckmäßigerweise kann dabei das Interferometer über eine an den entsprechenden elektrischen Schnittstellen angelegte Spannung in einen Durchlasszustand geschaltet werden.

Vorteilhaft kann im zweiten Ausrichtungsschritt wenigstens ein optischer Aktor als Sensor betrieben werden. Beispielsweise kann eine LED oder Laserdiode als eine Photodiode betrieben werden. Das kann den Vorteil haben, dass kein Betriebsstrom über die elektrischen Kontakte geleitet werden muss, sondern nur ein vergleichsweise geringer Photostrom, um den Kopplungsgrad zu bestimmen.

### Ausführungsbeispiele

Die Erfindung soll nachfolgend anhand von Ausführungsbeispielen unter Zuhilfenahme von Zeichnungen näher erläutert werden. Hierzu zeigen:
- Fig. 1a: einen Chip eines ersten Ausführungsbeispiels nach dem ersten Ausrichtungsschritt in einer ersten Position zum Kontaktierungsmodul angeordnet,
- Fig. 1b: das erste Ausführungsbeispiel beim zweiten Ausrichtungsschritt
- Fig. 1c: das erste Ausführungsbeispiel nach dem dritten Ausrichtungsschritt.
- Fig. 2a: einen Chip eines zweiten Ausführungsbeispiels nach dem ersten Ausrichtungsschritt in einer ersten Position zum Kontaktierungsmodul angeordnet,
- Fig. 2b: das zweite Ausführungsbeispiel beim zweiten Ausrichtungsschritt
- Fig. 2c: das zweite Ausführungsbeispiel nach dem dritten Ausrichtungsschritt.
- Fig. 3: den vierten Schritt einer Abwandlung des zweiten Ausführungsbeispiels
- Fig. 4: eine Scanvorschrift beim zweiten Ausrichtungsschritt.
- Fig.5: zeigt das dazugehörige Scanfeld

Mit einem erfindungsgemäßen Verfahren werden von auf einem Wafer angeordnete optoelektronische Chips 1 mit elektrischen Schnittstellen in Form von Kontaktpads 1.1 und hierzu fest angeordnete optische Schnittstellen in Form von optischen Umlenkelementen 1.2, z.B. Gitterkopplern oder Spiegeln, mit einem spezifischen Kopplungswinkel α getestet. Der spezifische Kopplungswinkel α stellt einen Winkel dar, den ein optisches Signal bzw. dessen Zentralstrahl mit einem Lot auf den Chip 1 einschließt. Er ist typischerweise größer 0° und kleiner 25°. Ein gängiger Wert für den spezifischen Koppelungswinkel α in Luft liegt z.B. bei 11,6° und bezieht sich auf die zur Kopplung in der Endanwendung des Chips verwendeten Glasfasern mit entsprechendem Keilanschliff.

Dabei wird gleich einem Verfahren des Standes der Technik ein Wafer von einem in x -, y-und z- Richtung eines kartesischen Koordinatensystems gegenüber einem Kontaktierungsmodul 2, verstellbaren und um die z Achse drehbaren Positioniertisch 3 aufgenommen. Das Kontaktierungsmodul 2 verfügt neben über zu den Chips 1 zuordenbaren elektrische Schnittstellen 2.1 auch über hierzu zuordenbaren optische Schnittstellen 2.2. Die elektrischen Schnittstellen und die optischen Schnittstellen der Chips 1 werden im Waferverbund in unterschiedlichen Verfahrensschritten hergestellt, so dass sie jeweils untereinander zwar nur geringe Lagetoleranzen aufweisen, die durch die elektrischen Schnittstellen gebildete Anordnungen können jedoch gegenüber den durch die optischen Schnittstellen gebildete Anordnungen, insbesondere von Wafer zu Wafer, Toleranzabweichungen haben. Gleiches gilt für die Toleranzen des Kontaktiermoduls. Außerdem kann der Kopplungswinkel α toleranzbehaftet sein. Insbesondere kann sich der Kopplungswinkel von Wafer zu Wafer toleranzbedingt unterscheiden.

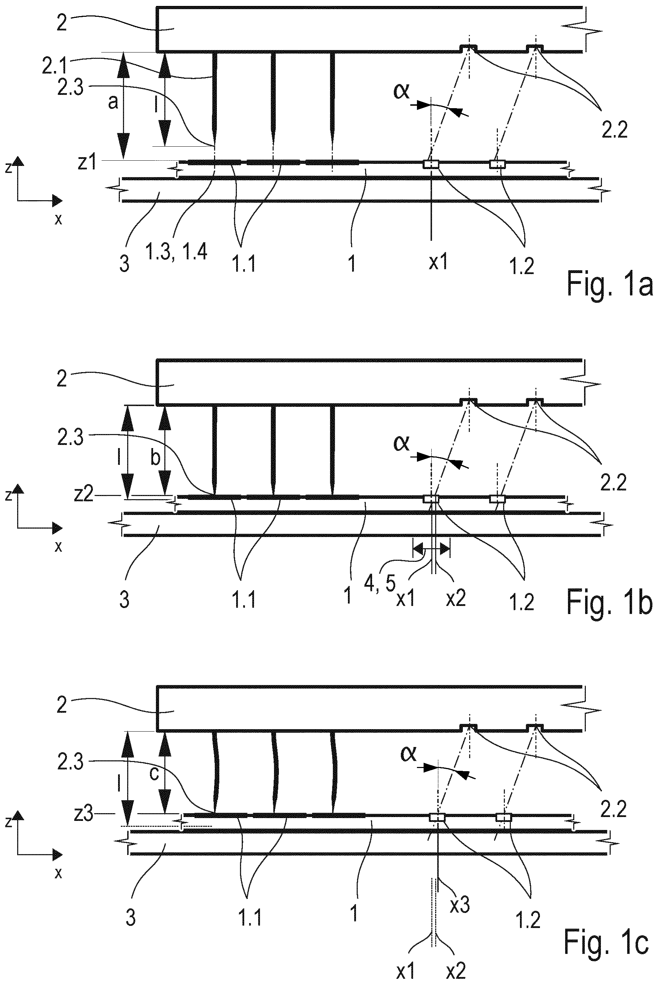

In einem ersten Ausrichtungsschritt, wird der Wafer dem Kontaktierungsmodul 2 so zugestellt, dass die an dem Kontaktierungsmodul 2 vorhandenen elektrischen Schnittstellen in Form von Nadeln 1.1, in eine erste Position (Nominalposition), lotrecht oberhalb von vorbestimmten Stellen 1.4, welche den Mittelpunkten 1.3 der Kontaktpads 1.1 entsprechen, eines ersten der Chips 1 angeordnet werden. Während der Justierung weist der Kontaktierungsmodul in z-Richtung einen Justierabstand a auf, größer der freien Länge I der Nadeln 2.1 zu dem Chip 1, sodass es zu keinem Kontakt zwischen den Nadelspitzen der Nadeln 2.1 und den Kontaktpads 1.1 kommen kann. Das entspricht einer ersten Position (x1, y1, z1) mit einer z-Koordinate z1. Siehe hierzu **Fig. 1a****,** wobei hier der Einfachheit halber, wie auch in den anderen Figuren, auf die Darstellung der Justierung in y-Richtung verzichtet wurde. Entsprechend sind Stellwege während einzelner Justierschritte nur als Stellwege in x-Richtung dargestellt. In einer nicht figürlich dargestellten Abwandlung dieses Ausführungsbeispiels sind die vorbestimmten Stellen von den Mittelpunkten der Kontaktpads beabstandet angeordnet.

Der Ablauf dieses ersten Justierschrittes erfolgt vorteilhaft gemäß einer aus der Praxis bekannten festen Routine. Dabei misst eine Kamera die Nadeln 2, durch Fokussierung auf die Nadelspitzen, und eine zweite Kamera misst die Kontaktpads 1.1 des Chips 1 ein. Beide Kameras sind vorher über ein Normal zueinander referenziert worden. Das ermöglicht anschließend die genaue Berechnung der optimalen Position (Nominalposition) der Nadeln 2 in Bezug auf die Kontaktpads 1.1 und damit die Positionierung des Kontaktmoduls 2 zum Chip 1. Meistens geschieht das über Regression und Extrapolation der Messwerte. Zudem wird zu jeder gefundenen Nadel 2 auch ein Kontaktpad 1.1 als Gegenstück erwartet. In diese Routine kann durch den Nutzer im Regelfall nicht eingegriffen werden. Auch können meist keine alternativen Strukturen wie Justiermarken etc. für die Positionierung verwendet werden. Über die Kameras wird nicht nur die x-y Position sowie eine Verdrehung um die z-Achse korrigiert, sondern auch die z-Position ermittelt. Bezugspunkte für die Nadeln 2.1 sind deren Nadelspitzen 2.3.

Es ist dem Fachmann klar, dass aufgrund von Lagetoleranzen der Nadelspitzen 2.3 zueinander und der Mittelpunkte der Kontaktpads 1.1 zueinander zeitgleich nicht wirklich alle Nadelspitzen exakt oberhalb der Mittelpunkte der Kontaktpads 1.1 angeordnet werden können und man letztendlich eine Position einjustiert in der die mittlere Abweichung am geringsten ist. Die Lagetoleranz der elektrischen Schnittstellen zueinander, ist jedoch vernachlässigbar klein im Vergleich zu der Lagetoleranz der Anordnung der elektrischen Schnittstellen zu der Anordnung der optischen Schnittstellen eines Chips 1, was seine Ursache insbesondere darin hat, dass die elektrischen Schnittstellen und die optischen Schnittstellen nacheinander mit unterschiedlichen Prozessschritten hergestellt werden. Gleiches gilt für die Toleranzen des Kontaktiermoduls. Außerdem kann der Kopplungswinkel α toleranzbehaftet sein. Insbesondere kann sich der Kopplungswinkel von Wafer zu Wafer toleranzbedingt unterscheiden.

Da die Herstellung der elektrischen Schnittstellen bzw. die Herstellung der optischen Schnittstellen für alle Chips eines Wafers jeweils in einem Verfahrensablauf erfolgt ist die Lageabweichung zwischen den Anordnungen der elektrischen Schnittstellen und den Anordnungen der optischen Schnittstellen einzelner Chips eines Wafers wenigstens annähernd gleich.

Nachdem die Anordnung der elektrischen Kontakte des Chips 1 (Nadeln 2.1) zu den elektrischen Kontakten des Kontaktierungsmodul 2 (Kontaktpads 1) ausgerichtet ist, weicht die tatsächliche Position der optischen Schnittstellen des Chips zu den optischen Schnittstellen am Kontaktierungsmodul 2.2 aufgrund verschiedener Ursachen von einer Solllage ab, siehe **Fig. 1a****.**

So weicht erstens die Lage der optischen Schnittstellen am Chip 1 von ihrer Sollposition in x-, y-, z- und um die z-Richtung statistisch veränderlich bei jedem Wafer ab, während die Abweichungen um die x- und um die y-Richtung durch die Ausrichtung des Positioniertisches 3 nach erfolgter Lagefixierung des Chips 1 und damit des Wafers als unveränderlich angenommen werden können (systematische Abweichungen). Außerdem kann der Kopplungswinkel von einem Sollwinkel abweichen.

Zweitens gibt es eine Abweichung der Lage der optischen Schnittstellen am Kontaktierungsmodul 2.2 von einer Solllage in Bezug zu den Nadeln 2.1, abhängig von der Montagegenauigkeit des optischen Moduls, welches integraler Bestandteil des Kontaktierungsmoduls ist. Dies betrifft nicht nur Lageabweichungen in x-, y- und z- Richtung, sondern auch Verkippungen um die z-, sowie um die x- und um die y-Richtung. Es handelt sich bei allen 6 Parametern um montagebedingte, systematische Abweichungen.

Und drittens kommt es über die Lebensdauer des Kontaktierungsmoduls 2 zu veränderlichen Abweichungen. Der Grund dafür ist die mechanische Abnutzung und damit Formänderung der Nadelspitzen sowie mögliche Verbiegungen und der daraus resultierenden Änderung im Fitergebnis.

Über die Kameramessung korrigiert der Positioniertisch 3 de facto die Position des gesamten Kontaktierungsmoduls 2 zum Chip/Wafer entsprechend nach - und ändert damit auch aufgrund des spezifischen Kopplungswinkels des jeweiligen optischen Umlenkelementes, insbesondere eines Gitterkopplers, die Position der Anordnung der optischen Schnittstellen des Kontaktierungsmoduls 2.2 zu der Anordnung der optischen Schnittstellen am Chip 1.

Ausgehend von der ersten Position (x1, y1, z1) wird in einem zweiten Ausrichtungsschritt (siehe hierzu **Fig. 1b****)** eine zweite Position (x2, y2, z2) ermittelt. Dazu wird zunächst der Positioniertisch (3) dem Kontaktierungsmodul (2) in z-Richtung in einen zweiten Abstand (b) zugestellt, bei dem die Nadelspitzen (2.1) an den Kontaktpads (1.1) anliegen. Dadurch wird bewirkt, dass über die jeweils einander zugeordneten Schnittstellen elektrische Signale und über die jeweils einander zugeordneten optischen Schnittstellen optische Signale übertragbar sind. Nun erfolgt im zweiten Ausrichtungsschritt eine relative Ausrichtung der optischen Umlenkelemente (1.2) zu den an dem Kontaktierungsmodul (2) vorhandenen optischen Schnittstellen (2.2). Dabei wird in einem Scanfeld (4, 5) kleiner einer xy- Ausdehnung der Kontaktpads (1.1) der Positioniertisch (3) in Scanpositionen Ps[i] = (xs[i], ys[i], z2) innerhalb eines Scanbereichs (4, 5) gegenüber den x- und/oder y Koordinaten der ersten Position in x-Richtung (4) und y-Richtung (5) ausgelenkt. Der Scan erfolgt also in einer xy- Ebene. In weiteren nicht figürlich dargestellten Abwandlungen des Beispiels kann der Scan außerdem eine Zustellung in z-Richtung umfassen, beispielsweise kann der Scan in einer yz-Ebene erfolgen.

An den Scanpositionen (xs[i], ys[i], zs[i]) wird über wenigstens eine -hier zwei- der optischen Schnittstellen des Kontaktierungsmoduls (2.2) und eines der optischen Umlenkelemente (1.2) ein optisches Signal gekoppelt.

Die zweite Position (x2, y2, z2) ist dadurch definiert, dass das optische Signal mit einem maximalen Kopplungsgrad gekoppelt wird, wobei der Kopplungsgrad mittels wenigstens eines über wenigstens eine elektrische Schnittstelle (1.2, 2.1) übertragenen elektrischen Signals bestimmt wird. Für eine Photodiode werden zwei der drei dargestellten elektrischen Schnittstellen benutzt. Alternativ kann eine der beiden benutzten Schnittstellen durch einen Substratkontakt des Wafers ersetzt werden. Werden mehrere optische Schnittstellen gleichzeitig gekoppelt, kann der Mittelwert des Kopplungsgrades aus mehreren Schnittstellen zur weiteren Betrachtung verwendet werden.

In der Darstellung liegt die zweite Position an der von x1 verschiedenen x-Koordinate x2. Siehe hierzu **Fig. 1b****.** Die zweite Position braucht nicht angefahren zu werden, es reicht aus, wenn diese beispielsweise mittels Regression aus den Kopplungsgraden an den Scanpositionen ermittelt ist.

In einem dritten Ausrichtungsschritt wird der erste der Chips (1) an eine dritte Position (x3, y3, z3) gebracht wird, indem zunächst die x3-und y3-Koordinate des Positioniertisches eingestellt und anschließend in z-Richtung in einen dritten Abstand c, welcher kleiner als der zweite Abstand b ist, zugestellt wird. Dabei liegen die Nadelspitzen (2.3) an den Kontaktpads (1.1) mit einer vorbestimmten Andruckkraft an, wie in **Fig. 1c** dargestellt ist. Das wird erreicht indem der optische Arbeitsabstand kleiner der freien Länge der Nadeln I gewählt wird. Die Differenz wird als Overtravel oder auch Overdrive bezeichnet. Dabei können die Nadeln beispielsweise elastisch knicken oder einfedern. Ein elastisches Knicken ist hier übertrieben dargestellt, um den Effekt zu veranschaulichen. Im zweiten Ausrichtungsschritt wird ein kleinerer Overtravel gewählt als beim dritten Ausrichtungsschritt. Der zweite Abstand b ist größer als der dritte Abstand c. Dadurch können die Kontaktpads beim Scan geschont werden.

Mit dem Overtravel wird ein sicherer elektrischer Kontakt der Nadeln mit den Kontaktpads gewährleistet (geringer Kontaktwiderstand). Nach dem ersten leichten Kontakt der Nadeln mit den Kontaktpads wird der Wafer im dritten Ausrichtungsschritt noch um einige 10µm in z-Richtung nach oben gefahren. Damit werden zwei Sachen erreicht. Einerseits wird damit ein Durchbrechen von ggf. vorhandenen Oxidoberflächen bewirkt, so dass ein reproduzierbarer, niederohmiger Kontakt erreicht wird. Andererseits wird durch den Overtravel ein konstanter Anpressdruck der Nadeln erzeugt, da die Nadeln aufgrund des zusätzlichen Stellweges entsprechend einfedern und eine Andruckkraft auf das Kontaktpad ausüben. Diese Andruckkraft ist je nach verwendetem Nadeltyp unterschiedlich, man kann aber größenordnungsmäßig von ca. 0,03 N pro Nadel ausgehen. Typischerweise wird der Overtravel in Vielfachen von MIL angegeben (amerik. 1mil = 1/1000 Zoll = 0,0254mm)

Bei einem Kontaktierungsmodul, bei dem die Anordnung der Nadel eine feste Lage zu den optischen Schnittstellen aufweist, muss der Wert des Overtravels bei der finalen Justierung des Chips berücksichtigt werden, sodass im kontaktierten Zustand sichergestellt wird, dass ein optischer Arbeitsabstand zwischen den optischen Schnittstellen des Kontaktierungsmoduls und dem Chip gegeben ist, beim dem eine maximale Einkopplung der optischen Signale gegeben ist. Die dritte Position (x3, y3, z3) wird aus der zweiten Position und dem Kopplungswinkel (α) des betreffenden optischen Umlenkelementes (1.2) für den dritten Abstand (c) bereits vor dem dritten Ausrichtungsschritt berechnet. Dadurch ist es möglich, zuerst die x-und y-Koordinaten der dritten Position einzustellen und danach die z-Koordinate auf den gewünschten Arbeitsabstand c zuzustellen. Auf diese Weise wird verhindert, dass die Nadeln die Pads zerkratzen.

Um den optischen Arbeitsabstand c einzustellen wird der Chip in die dritte Position gebracht. In dieser ist der finale Justierzustand hergestellt, in dem sowohl die elektrischen als auch die optischen Schnittstellen von Chip und Kontaktierungsmodul bestmöglich zueinander ausgerichtet sind, das heißt eine bestmögliche Messfähigkeit der optischen Signalflüsse gegeben ist (Maximum-Position der optischen Kopplung), wobei auch der elektrische Signalfluss gegeben ist. Zur Prüfung des Chips werden anschließend über die jeweils einander zugeordneten Schnittstellen elektrische bzw. optische Signale geleitet.

Der Justierweg von der ersten Position (Nominalposition) in die dritte Position (Maximum-Position der optischen Kopplung) stellt einen Versatz (Offset) dar (in Fig. 1c, als Koordinaten Vergleich der Koordinaten x3 zu x1 und x2 sowie als Koordinate z3 dargestellt) der vorteilhaft gespeichert wird und bei der Einjustierung aller weiteren Chips auf diesem Wafer mitberücksichtigt wird. D.h. die Nominalposition des Positioniertisches wird um den entsprechenden Versatz als Differenz x3-x1 in x- Richtung (siehe Fig. 1c) und Differenz y3-y1 in y- Richtung (nicht dargestellt) korrigiert. Das setzt jedoch eine entsprechend Verschiebung der Nadeln über den Kontaktpads voraus, die noch tolerierbar ist.

Diese Prozedur muss nur einmal pro Wafer oder auch in nur größeren zeitlichen Abständen durchgeführt werden.

Zudem kann dieser Versatzwert (Offset-Wert), d.h. die Differenz x3-x1 sowie die Differenz y3-y1 und seine Änderungen über die Zeit beobachtet werden und lässt damit Aussagen über die Abnutzung und damit verbundene Veränderung der Nadeln zu.

Zu Erhöhung der Genauigkeit der Bestimmung des Versatzes kann der Rasterscan auch an mehreren Chips des Wafers vor Beginn der Prüfung aller Chips des Wafers durchgeführt und die Ergebnisse gemittelt werden.

Der benötigte Overtravel, d.h. die Differenz c-I, kann sich über die Lebensdauer des Kontaktierungsmoduls aufgrund eines "Einlaufens" oder durch Abnutzung der Nadeln ändern, womit sich der Arbeitsabstand c verringert.

Die direkte Überwachung des optischen Arbeitsabstandes ist wichtig, um die definierten optischen Kopplungseigenschaften zwischen dem Kontaktierungsmodul und dem Chip zu gewährleisten (Messfähigkeit) und Kollisionen der optischen Schnittstellen von Kontaktierungsmodul und Chips zu verhindern (wenige 10-100µm Abstand im Betrieb).

Dafür kann ein fest im Kontaktierungsmodul integrierter Abstandssensor verwendet werden, z.B. ein kapazitiver Abstandssensor. Dieser ermöglicht eine Kontrolle des realen optischen Arbeitsabstandes. In Kombination mit einer aktiven Regelung kann der Arbeitsabstand durch Verfahren des Positioniertisches in z-Richtung aktiv nachgeregelt werden und bei Bedarf ein Hard Stop für die Unterschreitung eines Mindestarbeitsabstandes einprogrammiert werden, z.B. um eine Kollision durch Fehlbedienung des Operators zu vermeiden.

Typischerweise ist eine Veränderung der Nadelspitzenpositionen bei der Erstinbetriebnahme des Kontaktierungsmoduls zu erwarten (Einlaufverhalten). Dies kann durch eine mehrfache Kontaktsimulation vor der Einjustierung eines ersten Chips vorweggenommen werden (Voraltern), womit der Wert des einzustellenden Versatzes reduziert werden kann.

Üblicherweise weisen alle optischen Schnittstellen der Chips, verkörpert durch Gitterkoppler, Kopplungswinkel mit einem gleichen Winkelbetrag und einer gleichen Ausrichtung auf, so dass sich aus einer Änderung des optischen Arbeitsabstandes Δb entsprechend eine gleiche relative Änderung ΔX der optimalen Koppelposition für alle optischen Schnittstellen ergibt.

Typischerweise liegt die Änderung des optischen Arbeitsabstandes Δb im Bereich <50µm. Bei einer Änderung des optischen Arbeitsabstandes von beispielsweise 10µm und einem Kopplungswinkel α von 11.6° in der x-z-Ebene ergäbe sich damit in x-Richtung eine Änderung der optimalen Koppelposition Δx von 2µm. Bei einer Änderung des optischen Arbeitsabstandes Δb von 20µm ergäbe sich in x-Richtung eine Änderung der optimalen Koppelposition ein Δx von 4µm. Dies kann durch die oben beschriebene Korrektur noch abgefangen werden, d.h. der Positioniertisch wird in x-Richtung per Steuerbefehl unter der Annahme nachkorrigiert, dass die Nadeln immer noch ausreichend sicher auf die Kontaktpads treffen.

Die Anforderungen an die Genauigkeit der Justierschritte kann reduziert werden, wenn die zur Prüfung des Chips über die jeweils einander zugeordneten Schnittstellen geleiteten optische Signale die einkoppelnde Schnittstelle jeweils überstrahlen.

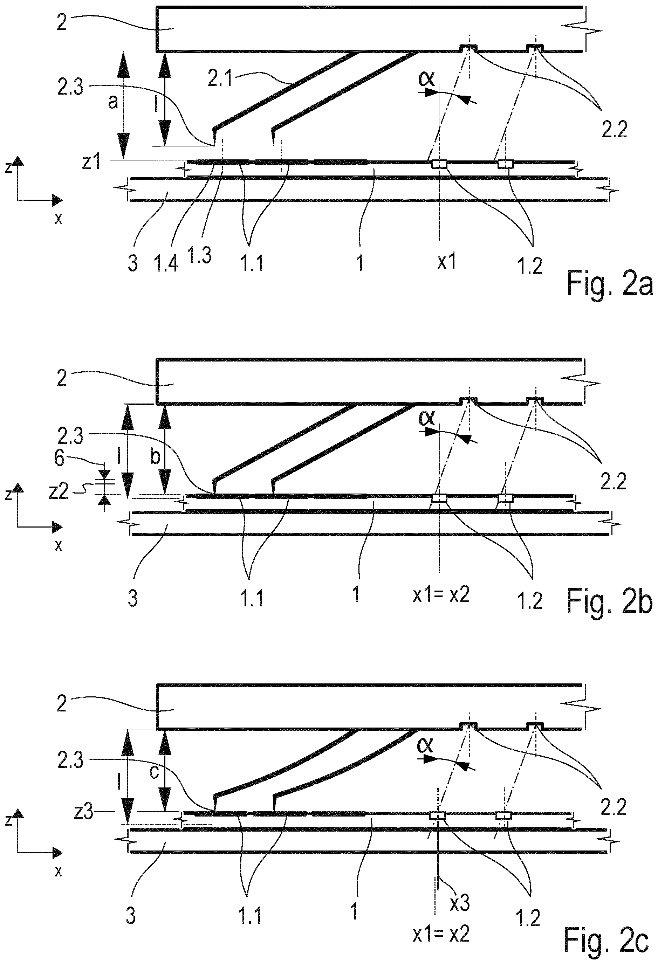

Fig. 2a zeigt einen Chip eines zweiten Ausführungsbeispiels nach dem ersten Ausrichtungsschritt in einer ersten Position zum Kontaktierungsmodul angeordnet. Im Unterschied zum ersten Ausführungsbeispiel werden hier Cantilever-Nadeln 2.1 eingesetzt. In einem ersten Ausrichtungsschritt wird der Wafer dem Kontaktierungsmodul (2) so zugestellt, dass die Nadelspitzen (2.3) in einer ersten Position (x1, y1, z1) jeweils in z-Richtung beabstandet über einer vorbestimmten Stelle (1.4) des zugeordneten Kontaktpads (1.1) eines ersten der Chips (1) angeordnet sind, wobei das Kontaktierungsmodul (2) in z-Richtung einen ersten Abstand (a) zu dem ersten der Chips (1) aufweist, wobei der erste Abstand (a) größer ist als ein maximaler Abstand (I) der Nadelspitzen (2.3) zum Kontaktierungsmodul (2). Die vorbestimmten Stellen 1.4 sind hier außerhalb der Mitten 1.3 der Kontaktpads 1.1 vorgesehen.

Fig. 2b zeigt das zweite Ausführungsbeispiel beim zweiten Ausrichtungsschritt. Im Unterschied zum ersten Ausführungsbeispiel ist hier ein yz- Scan über einen Scanbereich in y Richtung 5 und z-Richtung 6 mit einer festen Koordinate x2=x1 vorgesehen. Hier kann der Scan vorteilhaft nach Überschreiten des maximalen Kopplungsgrades bei z2 abgebrochen werden. In einer Abwandlung des zweiten Ausführungsbeispiels erfolgt der Scan bei fester y-Koordinate y2=y1, dabei handelt es sich um einen Linienscan. In einer weiteren Abwandlung erfolgt der Scan bei fester z-Koordinate in einer xy-Ebene.

Fig. 2c zeigt das zweite Ausführungsbeispiel nach dem dritten Ausrichtungsschritt. Bei den Cantilever-Nadeln kann die Andruckkraft mittels elastischer Biegung aufgebracht werden. Der Dritte Ausrichtungsschritt erfolgt unmittelbar nach dem zweiten.

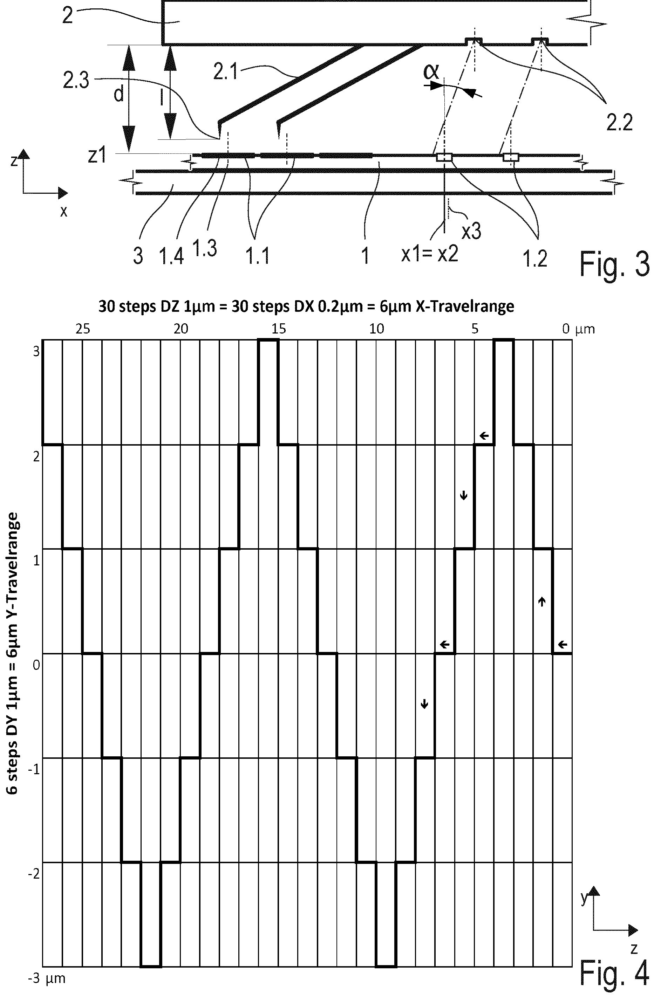

Fig. 3 zeigt einen vierten Ausrichtungsschritt einer weiteren Abwandlung des zweiten Ausführungsbeispiels. Hier wird der der Positioniertisch in -z-Richtung in einen vierten Abstand d abgestellt, wobei der vierte Abstand d größer ist als der maximale Abstand I der Nadelspitzen (2.3) zum Kontaktierungsmodul (2). Der vierte Ausrichtungsschritt erfolgt zwischen dem zweiten und dritten Ausrichtungsschritt.

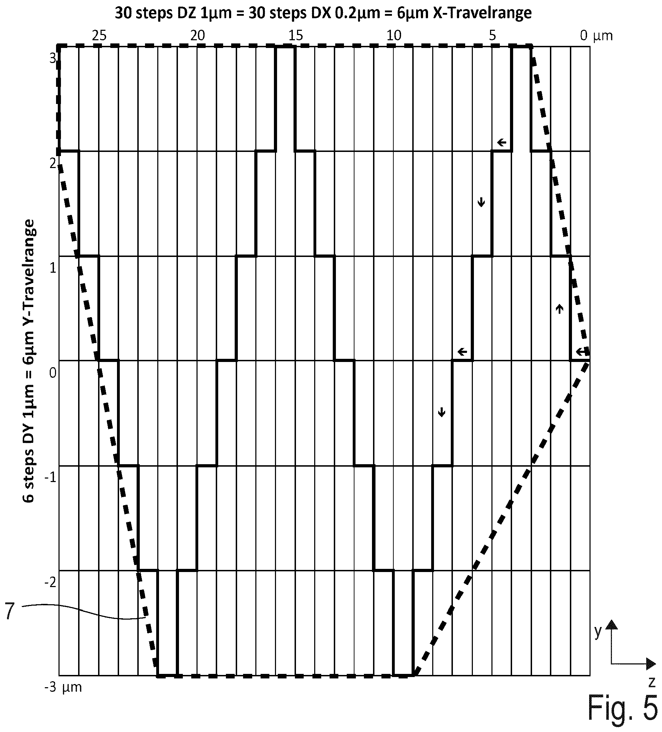

Fig. 4 zeigt eine Scanvorschrift eines yz-Scans beim zweiten Ausrichtungsschritt. Auf der Abszisse ist die z- Koordinate der Bahnkurve des Scans abzüglich der Koordinate z2 der zweiten Position aufgetragen. Auf der Ordinate ist die y Koordinate der Bahnkurve des Scans abzüglich der Koordinate y2 der zweiten Position aufgetragen. Die Bahnkurve (yz- Pfad) ist als dicke Linie im Diagramm dargestellt, deren Durchlaufrichtung ist mit Pfeilen angedeutet. Dabei sind die Scanpositionen der Reihe nach an den Ecken der eingezeichneten Bahnkurve gewählt. Der Scan beginnt in der Darstellung Mitte rechts an der zweiten Position (x2, y2, z2). Es werden 55 Scanpositionen verwendet. Die z-Koordinate steigt in 54 Schritten zu abwechselnd je 1µm und 0µm monoton an. Die y-Koordinate bewegt sich in Schrittweiten von -1µm, 0µm und 1µm in der dargestellten Weise zwischen y2-3µm und y2+3µm. Der Scanbereich beträgt 6µm in y- Richtung und 27µm in z-Richtung. Der Weg von 28µm in z-Richtung ist bei spezifischen Kopplungswinkel α=11,6° äquivalent zu einem Strahlversatz in x-Richtung von 5,5µm. Der in Fig. 5 dargestellte Scanbereich 7 ist das umrandende Polygon der Scanpositionen. Er ist flächig in einer yz-Ebene ausgebildet. Das Scanfeld (nicht figürlich dargestellt) als senkrechte z-Projektion des Scanbereichs wäre hier eindimensional (linienförmig) in y-Richtung verlaufend.

In einer nicht figürlich dargestellten Abwandlung der in Fig. 4 und 5 dargestellten Scanvorschrift bleibt die y-Koordinate fest und der Scan erfolgt als Linienscan in z-Richtung. Dann wäre das Scanfeld punktförmig.

### Bezugszeichenliste

- 1: Chip
- 1.1: Kontaktpad
- 1.2: optisches Umlenkelement
- 1.3: Mitte des Kontaktpads
- 1.4: vorbestimmte Stelle
- 2: Kontaktierungsmodul
- 2.1: Nadel
- 2.2: optische Schnittstelle am Kontaktierungsmodul
- 2.3.: Nadelspitze
- 3: Positioniertisch
- 4.: x- Scanbereich
- 5.: y- Scanbereich
- 6.: z- Scanbereich
- 7.: Scanbereich
- α: Kopplungswinkel
- a: erster Abstand
- b: zweiter Abstand
- c: dritter Abstand
- I: freie Länge der Nadel

## Patentansprüche

1. Verfahren zum Testen von auf einem Wafer angeordneten opto-elektronischen Chips (1), mit elektrischen Schnittstellen in Form von Kontaktpads (1.1) und hierzu fest angeordneten optischen Elementen, welche optische Schnittstellen in Form von optischen Umlenkelementen (1.2) mit einem spezifischen Kopplungswinkel (α) umfassen,
bei dem der Wafer von einem Positioniertisch (3) aufgenommen wird, der in x-, y- und z-Richtung eines kartesischen Koordinatensystems gegenüber einem Kontaktierungsmodul (2) verstellbar und um die z-Achse drehbar ist, wobei das Kontaktierungsmodul (2) den Kontaktpads (1.1) zugeordnete elektrische Schnittstellen in Form von Nadeln (2.1) mit Nadelspitzen (2.3) und den optischen Umlenkelementen (1.2) zugeordnete optische Schnittstellen (2.2) aufweist, und
• in einem ersten Ausrichtungsschritt der Wafer dem Kontaktierungsmodul (2) so zugestellt wird, dass die Nadelspitzen (2.3) in einer ersten Position (x1, y1, z1) jeweils in z-Richtung beabstandet über einer vorbestimmten Stelle (1.4) des zugeordneten Kontaktpads (1.1) eines ersten der Chips (1) angeordnet sind, wobei das Kontaktierungsmodul (2) in z-Richtung einen ersten Abstand (a) zu dem ersten der Chips (1) aufweist, wobei der erste Abstand (a) größer ist als ein maximaler Abstand (I) der Nadelspitzen (2.3) zum Kontaktierungsmodul (2),
**dadurch gekennzeichnet, dass**
• ausgehend von der ersten Position (x1, y1, z1) in einem zweiten Ausrichtungsschritt eine zweite Position (x2, y2, z2) ermittelt wird, indem der Positioniertisch (3) dem Kontaktierungsmodul (2) in z-Richtung in einen zweiten Abstand (b) zugestellt wird, bei dem die Nadelspitzen (2.1) an den Kontaktpads (1.1) anliegen, so dass über die jeweils einander zugeordneten Schnittstellen elektrische Signale und über die jeweils einander zugeordneten optischen Schnittstellen optische Signale übertragbar sind, wobei im zweiten Ausrichtungsschritt eine relative Ausrichtung der optischen Umlenkelemente (1.2) zu den an dem Kontaktierungsmodul (2) vorhandenen optischen Schnittstellen (2.2) erfolgt, indem in einem Scanfeld (4, 5) kleiner einer xy-Ausdehnung der Kontaktpads (1.1) der Positioniertisch (3) in Scanpositionen Ps[i] = (xs[i], ys[i], zs[i]) innerhalb eines Scanbereichs (7) gegenüber den x- und/oder y Koordinaten der ersten Position in x- und/oder y-Richtung ausgelenkt und/oder in z-Richtung zugestellt wird, und an den Scanpositionen (xs[i], ys[i], zs[i]) über wenigstens eine der optischen Schnittstellen des Kontaktierungsmoduls (2.2) und eines der optischen Umlenkelemente (1.2) ein optisches Signal gekoppelt wird, wobei die zweite Position (x2, y2, z2) dadurch definiert ist, dass das optische Signal mit einem maximalen Kopplungsgrad gekoppelt wird, wobei der Kopplungsgrad mittels wenigstens eines über wenigstens eine elektrische Schnittstelle (1.2, 2.1) übertragenen elektrischen Signals bestimmt wird, und
• in einem dritten Ausrichtungsschritt der erste der Chips (1) an eine dritte Position (x3, y3, z3) gebracht wird, indem zunächst die x3-und y3-Koordinate des Positioniertisches eingestellt und anschließend in z-Richtung in einen dritten Abstand c, welcher kleiner als der zweite Abstand b ist, zugestellt wird, wobei die Nadelspitzen (2.3) an den Kontaktpads (1.1) mit einer vorbestimmten Andruckkraft anliegen, wobei die dritte Position (x3, y3, z3) aus der zweiten Position und dem Kopplungswinkel (α) des betreffenden optischen Umlenkelementes (1.2) für den dritten Abstand (c) vor dem dritten Ausrichtungsschritt berechnet wurde.

2. Verfahren zum Testen von auf einem Wafer angeordneten opto-elektronischen Chips (1) nach Anspruch 1, **dadurch gekennzeichnet,**
**dass** sich der dritte Ausrichtungsschritt unmittelbar an den zweiten Ausrichtungsschritt anschließt
oder
**dass** zwischen dem zweiten und dritten Ausrichtungsschritt ein vierter Ausrichtungsschritt vorgesehen ist, bei dem der Positioniertisch in -z-Richtung in einen vierten Abstand d abgestellt wird, wobei der vierte Abstand d größer ist als der maximale Abstand I der Nadelspitzen (2.3) zum Kontaktierungsmodul (2).

3. Verfahren zum Testen von auf einem Wafer angeordneten opto-elektronischen Chips (1) nach einem der vorgenannten Ansprüche, **dadurch gekennzeichnet,**
**dass** im zweiten Ausrichtungsschritt die Scanpositionen (xs[i], ys[i], zs[i]) in einer xy-Ebene (x, y, z2) und/oder auf einer Linie (x2, y2, z) und/oder in einer yz Ebene (x2, y, z) liegen.

4. Verfahren zum Testen von auf einem Wafer angeordneten opto-elektronischen Chips (1) nach einem der vorgenannten Ansprüche, **dadurch gekennzeichnet,**
**dass** eine sich aus der ersten Position und der zweiten oder der dritten Position des ersten der Chips (1) ergebende Lagedifferenz als Offset abgespeichert wird und für die Ausrichtung weiterer der Chips (1) berücksichtigt wird, nachdem diese in einem ersten Ausrichtungsschritt zum Kontaktierungsmodul (2) positioniert wurden.

5. Verfahren zum Testen von auf einem Wafer angeordneten opto-elektronischen Chips (1) nach einem der vorgenannten Ansprüche, **dadurch gekennzeichnet,**
**dass** der dritte Abstand c, bei dem die Nadeln (2.1) mit einer vorgegebenen Andruckkraft an den Kontaktpads (1.1) anliegen, überwacht wird und bei Änderungen der Andruckkraft der dritte Abstand korrigiert wird.

6. Verfahren zum Testen von auf einem Wafer angeordneten opto-elektronischen Chips (1) nach einem der vorgenannten Ansprüche, **dadurch gekennzeichnet,**
**dass** die Änderung des dritten Abstands c langfristig über die Einsatzdauer des Kontaktierungsmoduls (2) ermittelt wird und für die Verfahrensdurchführung die Nadeln (2.1) des Kontaktierungsmoduls (2) gegen neue Nadeln (2.1) ersetzt werden, wenn der dritte Abstand c einen vorgegebenen Minimalabstand unterschreitet.

7. Verfahren zum Testen von auf einem Wafer angeordneten opto-elektronischen Chips nach einem der vorgenannten Ansprüche, **dadurch gekennzeichnet,**
**dass** die über die jeweils einander zugeordneten Schnittstellen geleiteten optischen Signale beim Einkoppeln in einer der Schnittstellen diese überstrahlen.

8. Verfahren zum Testen von auf einem Wafer angeordneten opto-elektronischen Chips (1) nach einem der vorgenannten Ansprüche, **dadurch gekennzeichnet,**
**dass** die über die jeweils einander zugeordneten Schnittstellen geleiteten optischen Signale beim Einkoppeln in eine der Schnittstellen eine Tophat-Verteilung ihrer Strahlungsintensität aufweisen.

9. Verfahren zum Testen von auf einem Wafer angeordneten opto-elektronischen Chips (1)
nach einem der vorgenannten Ansprüche, **dadurch gekennzeichnet,**
**dass** wenigstens eine der optischen Elemente eines Chips einen elektrooptischen Sensor
und /oder einen elektrooptischen Aktor und/oder einen elektrooptischen Modulator umfasst.

10. Verfahren zum Testen von auf einem Wafer angeordneten opto-elektronischen Chips (1)
nach Anspruch 9, **dadurch gekennzeichnet,**
**dass**, der elektrooptische Sensor als eine Photodiode oder ein Phototransistor ausgebildet ist
und/ oder dass der elektrooptische Aktor als eine Lichtemitterdiode oder eine Laserdiode oder dass der elektrooptische Modulator als ein Mach-Zehnder-Interferometer ausgebildet ist.

11. Verfahren zum Testen von auf einem Wafer angeordneten opto-elektronischen Chips (1)
nach einem der Ansprüche 9 bis 10, **dadurch gekennzeichnet,**
**dass** im zweiten Ausrichtungsschritt wenigstens ein optischer Aktor als Sensor betrieben wird.

## Claims

1. Method for testing optoelectronic chips (1) arranged on a wafer and having electrical interfaces in the form of contact pads (1.1) and optical elements which are fixedly arranged in relation to said electrical interfaces and which comprise optical interfaces in the form of optical deflection elements (1.2) with a specific coupling angle (α),
wherein the wafer is accommodated by a positioning stage (3) which is adjustable vis-à-vis a contacting module (2) in the x-, y-, and z-direction of a Cartesian coordinate system and which is rotatable about the z-axis, the contacting module (2) having electrical interfaces in the form of needles (2.1) with needle tips (2.3) assigned to the contact pads (1.1) and optical interfaces (2.2) assigned to the optical deflection elements (1.2), and
• in a first alignment step, the wafer is moved toward the contacting module (2) in such a way that the needle tips (2.3) are arranged in a first position (x1, y1, z1), in each case with a spacing in the z-direction above a predetermined point (1.4) of the assigned contact pad (1.1) of a first of the chips (1), the contacting module (2) being at a first distance (a) from the first of the chips (1) in the z-direction and the first distance (a) being greater than a maximum distance (I) of the needle tips (2.3) from the contacting module (2),
**characterized in that**
• proceeding from the first position (x1, y1, z1), a second position (x2, y2, z2) is determined in a second alignment step by virtue of the positioning stage (3) being moved toward the contacting module (2) at a second distance (b) in the z-direction, in which the needle tips (2.1) abut against the contact pads (1.1) such that electrical signals are transferable via the respective interfaces assigned to one another and optical signals are transferable via the respective optical interfaces assigned to one another, with a relative alignment of the optical deflection elements (1.2) with respect to the optical interfaces (2.2) present on the contacting module (2) being implemented in the second alignment step by virtue of, in a scanning field (4, 5) smaller than an xy-extent of the contact pads (1.1), the positioning stage (3) being deflected in the x- and/or y-direction with respect to the x- and/or y-coordinates of the first position and/or being moved in the z-direction toward scanning positions Ps[i] = (xs[i], ys[i], zs[i]) within a scanning region (7), and an optical signal being coupled at the scanning positions (xs[i], ys[i], zs[i]) via at least one of the optical interfaces of the contacting module (2.2) and one of the optical deflection elements (1.2), with the second position (x2, y2, z2) being defined by virtue of the fact that the optical signal is coupled with a maximum degree of coupling, with the degree of coupling being determined by means of at least one electrical signal which is transferred via at least one electrical interface (1.2, 2.1), and
• in a third alignment step, the first of the chips (1) is brought into a third position (x3, y3, z3) by virtue of the x3- and y3-coordinate of the positioning stage being initially set and said positioning stage subsequently being moved in the z-direction toward a third distance c, which is shorter than the second distance b, with the needle tips (2.3) abutting against the contact pads (1.1) with a predetermined contact force, the third position (x3, y3, z3) having been calculated from the second position and the coupling angle (α) of the relevant optical deflection element (1.2) for the third distance (c) prior to the third alignment step.

2. Method for testing optoelectronic chips (1) arranged on a wafer according to Claim 1, **characterized**
**in that** the third alignment step immediately follows the second alignment step
or
**in that** a fourth alignment step is provided between the second and third alignment step and the positioning stage is moved away therein to a fourth distance d in the -z-direction, with the fourth distance d being greater than the maximum distance I of the needle tips (2.3) from the contacting module (2).

3. Method for testing optoelectronic chips (1) arranged on a wafer according to either of the preceding claims, **characterized**
**in that** the scanning positions (xs[i], ys[i], zs[i]) are located in an xy-plane (x, y, z2) and/or on a line (x2, y2, z) and/or in a yz-plane (x2, y, z) in the second alignment step.

4. Method for testing optoelectronic chips (1) arranged on a wafer according to any of the preceding claims, **characterized**
**in that** a positional difference arising from the first position and the second or the third position of the first of the chips (1) is stored as an offset and taken into consideration when aligning more of the chips (1) after these were positioned relative to the contacting module (2) in a first alignment step.

5. Method for testing optoelectronic chips (1) arranged on a wafer according to any of the preceding claims, **characterized**
**in that** the third distance c, at which the needles (2.1) abut against the contact pads (1.1) with a specified compression force, is monitored and the third distance is corrected in the case of changes in the compression force.

6. Method for testing optoelectronic chips (1) arranged on a wafer according to any of the preceding claims, **characterized**
**in that** the long-term change in the third distance c is determined over the use duration of the contacting module (2) and the needles (2.1) of the contacting module (2) are replaced by new needles (2.1) for the purposes of carrying out the method when the third distance c drops below a specified minimum distance.

7. Method for testing optoelectronic chips arranged on a wafer according to any of the preceding claims, **characterized**
**in that** the optical signals transmitted via the mutually assigned interfaces swamp one of the interfaces when input coupled therein.

8. Method for testing optoelectronic chips (1) arranged on a wafer according to any of the preceding claims, **characterized**
**in that** the optical signals transmitted via the mutually assigned interfaces have a top hat distribution of their radiation intensity when input coupled into one of the interfaces.

9. Method for testing optoelectronic chips (1) arranged on a wafer according to any of the preceding claims, **characterized**
**in that** at least one of the optical elements of a chip comprises an electro-optic sensor and/or an electro-optic actuator and/or electro-optic modulator.

10. Method for testing optoelectronic chips (1) arranged on a wafer according to Claim 9, **characterized**
**in that** the electro-optic sensor is designed as a photodiode or phototransistor and/or in that the electro-optic actuator is designed as a light-emitting diode or a laser diode or in that the electro-optic modulator is designed as a Mach-Zehnder interferometer.

11. Method for testing optoelectronic chips (1) arranged on a wafer according to either of Claims 9 and 10, **characterized**
**in that** at least one optical actuator is operated as a sensor in the second alignment step.

## Revendications

1. Procédé de test de puces opto-électroniques (1) agencées sur une tranche, comportant des interfaces électriques sous forme de pastilles de contact (1.1) et des éléments optiques agencés de manière fixe par rapport à celles-ci, qui comprennent des interfaces optiques sous forme d'éléments de déviation optiques (1.2) présentant un angle de couplage (α) spécifique,
dans lequel la tranche est reçue par une table de positionnement (3) qui est réglable dans les directions x, y et z d'un système de coordonnées cartésien par rapport à un module de mise en contact (2) et qui peut être mise en rotation autour de l'axe z, le module de mise en contact (2) comportant des interfaces électriques associées aux pastilles de contact (1.1), qui se présentent sous la forme d'aiguilles (2.1) dotées de pointes d'aiguille (2.3), et des interfaces optiques (2.2) associées aux éléments de déviation optiques (1.2), et
• au cours d'une première étape d'alignement, la tranche est rapprochée du module de contact (2) de telle sorte que les pointes d'aiguille (2.3) sont agencées à une première position (x1, y1, z1) respectivement espacée dans la direction z au-dessus d'un emplacement prédéterminé (1.4) de la pastille de contact (1.1) associée d'une première des puces (1), le module de contact (2) étant situé à une première distance (a) de la première des puces (1) dans la direction z, la première distance (a) étant supérieure à une distance maximale (I) des pointes d'aiguille (2.3) par rapport au module de contact (2),
**caractérisé en ce que**
• à partir de la première position (x1, y1, z1), une deuxième position (x2, y2, z2) est déterminée au cours d'une deuxième étape d'alignement, en rapprochant la table de positionnement (3) du module de mise en contact (2) dans la direction z à une deuxième distance (b) à laquelle les pointes d'aiguille (2.1) reposent sur les pastilles de contact (1.1), de telle sorte que des signaux électriques peuvent être transmis par l'intermédiaire des interfaces respectives associées les unes aux autres et que des signaux optiques peuvent être transmis par l'intermédiaire des interfaces optiques respectives associées les unes aux autres, dans lequel, au cours de la deuxième étape d'alignement, un alignement relatif des éléments de déviation optiques (1.2) est effectué par rapport aux interfaces optiques (2.2) présentes sur le module de contact (2), en faisant en sorte que, dans un champ de balayage (4, 5) plus petit qu'une extension xy des pastilles de contact (1.1), la table de positionnement (3) soit déviée vers des positions de balayage Ps[i] = (xs[i], ys[i], zs[i]) à l'intérieur d'une zone de balayage (7) par rapport aux coordonnées x et/ou y de la première position dans la direction x et/ou y et/ou soit rapprochée dans la direction z, et qu'un signal optique soit couplé aux positions de balayage (xs[i], ys[i], zs[i]) par l'intermédiaire d'au moins l'une des interfaces optiques du module de mise en contact (2.2) et de l'un des éléments de déviation optiques (1.2), la deuxième position (x2, y2, z2) étant définie par le fait que le signal optique est couplé avec un degré de couplage maximum, le degré de couplage étant déterminé au moyen d'au moins un signal électrique transmis par l'intermédiaire d'au moins une interface électrique (1.2, 2.1), et
• au cours d'une troisième étape d'alignement, la première des puces (1) est amenée à une troisième position (x3, y3, z3) en réglant tout d'abord les coordonnées x3 et y3 de la table de positionnement puis en l'amenant, dans la direction z, à une troisième distance c, qui est inférieure à la deuxième distance b, les pointes d'aiguille (2.3) reposant sur les pastilles de contact (1.1) avec une force de pression prédéterminée, la troisième position (x3, y3, z3) ayant été calculée avant la troisième étape d'alignement à partir de la deuxième position et de l'angle de couplage (α) de l'élément de déviation optique (1.2) concerné pour la troisième distance (c).

2. Procédé de test de puces opto-électroniques (1) agencées sur une tranche selon la revendication 1, **caractérisé en ce que**
la troisième étape d'alignement suit immédiatement la deuxième étape d'alignement
ou
**en ce qu'**il est prévu, entre les deuxième et troisième étapes d'alignement, une quatrième étape d'alignement au cours de laquelle la table de positionnement est arrêtée à une quatrième distance d dans la direction z, la quatrième distance d étant supérieure à la distance maximale I des pointes d'aiguille (2.3) par rapport au module de mise en contact (2).

3. Procédé de test de puces opto-électroniques (1) agencées sur une tranche selon l'une quelconque des revendications précédentes, **caractérisé en ce que**,
au cours de la deuxième étape d'alignement, les positions de balayage (xs[i], ys[i], zs[i]) se situent dans un plan xy (x, y, z2) et/ou sur une droite (x2, y2, z) et/ou dans un plan yz (x2, y, z).

4. Procédé de test de puces opto-électroniques (1) agencées sur une tranche selon l'une quelconque des revendications précédentes, **caractérisé en ce que**
une différence de position obtenue à partir de la première position et de la deuxième ou de la troisième position de la première des puces (1) est mémorisée sous la forme d'un décalage et est prise en compte pour l'alignement de certaines autres des puces (1), après que celles-ci ont été positionnées par rapport au module de mise en contact (2) au cours d'une première étape d'alignement.

5. Procédé de test de puces opto-électroniques (1) agencées sur une tranche selon l'une quelconque des revendications précédentes, **caractérisé en ce que**
la troisième distance c, à laquelle les aiguilles (2.1) reposent sur les pastilles de contact (1.1) avec une force de pression prédéfinie, est surveillée et **en ce que** la troisième distance est corrigée lors de modifications de la force de pression.

6. Procédé de test de puces opto-électroniques (1) agencées sur une tranche selon l'une quelconque des revendications précédentes, **caractérisé en ce que**
la modification de la troisième distance c est déterminée à long terme sur la durée d'utilisation du module de mise en contact (2) et, pour la mise en œuvre du procédé, les aiguilles (2.1) du module de mise en contact (2) sont remplacées par de nouvelles aiguilles (2.1) lorsque la troisième distance c devient inférieure à une distance minimale prédéfinie.

7. Procédé de test de puces opto-électroniques agencées sur une tranche selon l'une quelconque des revendications précédentes, **caractérisé en ce que**
les signaux optiques acheminés par l'intermédiaire des interfaces respectivement associées les unes aux autres, lorsqu'ils sont injectés dans l'une des interfaces, irradient cette dernière.

8. Procédé de test de puces opto-électroniques (1) agencées sur une tranche selon l'une quelconque des revendications précédentes, **caractérisé en ce que**
les signaux optiques acheminés par l'intermédiaire des interfaces respectivement associées les unes aux autres présentent, lorsqu'ils sont injectés dans l'une des interfaces, une distribution en haut-de-forme de leur intensité de rayonnement.

9. Procédé de test de puces opto-électroniques (1) agencées sur une tranche selon l'une quelconque des revendications précédentes, **caractérisé en ce que**
au moins l'un des éléments optiques d'une puce comprend un capteur électro-optique et/ou un actionneur électro-optique et/ou un modulateur électro-optique.

10. Procédé de test de puces opto-électroniques (1) agencées sur une tranche selon la revendication 9, **caractérisé en ce que**
le capteur électro-optique est réalisé sous la forme d'une photodiode ou d'un phototransistor et/ou **en ce que** l'actionneur électro-optique est réalisé sous la forme d'une diode électroluminescente ou d'une diode laser ou en ce que le modulateur électro-optique est réalisé sous la forme d'un interféromètre de Mach-Zehnder.

11. Procédé de test de puces opto-électroniques (1) agencées sur une tranche selon l'une quelconque des revendications 9 à 10, **caractérisé en ce que**,
lors de la deuxième étape d'alignement, au moins un actionneur optique est utilisé en tant que capteur.
